Europäisches Patentamt

European Patent Office

Office européen des brevets

⑩

(11) Publication number: **0 131 433**
**B1**

(12) **EUROPEAN PATENT SPECIFICATION**

(45) Date of publication of patent specification: **12.09.90**

(21) Application number: **84304597.2**

(22) Date of filing: **05.07.84**

(51) Int. Cl.⁵: **H 05 H 1/46, H 01 J 37/32**

(54) Plasma processing apparatus.

(30) Priority: **08.07.83 JP 124511/83**

(43) Date of publication of application:
**16.01.85 Bulletin 85/03**

(45) Publication of the grant of the patent:
**12.09.90 Bulletin 90/37**

(84) Designated Contracting States:
**DE FR GB**

(56) References cited:
**EP-A-0 090 586      NL-A-8 303 458**
**EP-A-0 106 497      US-A-4 362 632**

**PATENTS ABSTRACTS OF JAPAN, vol. 6, no. 264 (E-150) 1142r, 23rd December 1982; & JP - A - 57 159 016 (SUMITOMO DENKI KOGYO K.K.) 01-10-1982**

**PATENTS ABSTRACTS OF JAPAN, vol. 7, no. 204 (E-197) 1349r, 9th September 1983; & JP - A - 58 100 431 (FUJITSU K.K.) 15-06-1983**
**PATENTS ABSTRACTS OF JAPAN.vol.7 No.22 (C-148) (1167),28.1.83., and JP-A-57-177975 (1.11.82)**

(73) Proprietor: **FUJITSU LIMITED**
**1015, Kamikodanaka Nakahara-ku**
**Kawasaki-shi Kanagawa 211 (JP)**

(72) Inventor: **Fujimura, Shuzo c/o Fujitsu Limited**
**Patent Department 1015 Kamikodanaka**
**Nakahara-ku**
**Kawasaki-shi Kanagawa, 211 (JP)**
Inventor: **Yano, Hiroshi c/o Fujitsu Limited**
**Patent Department 1015 Kamikodanaka**
**Nakahara-ku**
**Kawasaki-shi Kanagawa, 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to plasma processing apparatus for use for instance in the fabrication of integrated circuit semiconductor devices (IC).

In processes for forming fine patterns in IC devices, etching methods and 'ashing' methods are used: these methods are used in processes for etching off protective layers of silicon, silicon dioxide, or silicon nitride on wafer surfaces, and in a process for removing, or 'ashing', a photoresist mask, which is usually an organic layer.

From the beginning of the IC industry, 'wet' etching methods have been employed, utilizing sulphuric, hydrochloric, or phosphoric acids, but recently the 'wet' etching methods are being displaced by 'dry' etching methods, a plasma etching method for example.

A plasma etching method has various advantages as compared with 'wet' etching methods, such as a capability for achieving fine resolution and causing less under-cutting, allowing a reduction of the number of fabricating processes involved, for example by elimination of wafer handling for rinsing and drying, and affording greater cleanness and the like. In particular, plasma etching makes it possible to perform sequential etching and stripping operations on the same machine, opening the door to fully automated IC fabrication processes.

A plasma is a highly ionized gas with nearly equal numbers of positive and negative charged particles plus free radicals. The free radicals are electrically neutral atoms or molecules that can actively take part in chemical bonding. The free radicals generated in a plasma, acting as a reactive species, chemically combine with materials to be etched, to form volatile compounds which are removed from the plasma etching system by an evacuating device.

A plasma etching apparatus comprises a plasma generation region, a reaction region (reactor) and an evacuating device.

Generally, an IC device exposed to plasma is damaged by ion bombardment, irradiation with ultraviolet rays, soft X-rays and the like, so an IC device to be worked (etched or ashed) should be shielded from the plasma. A plasma is generated in a gas of a pressure of approximately 66.661 to 266.644 Pa (0.5 to 2 Torr) by the application of electromagnetic, e.g. microwave, energy to the gas, which energy is supplied by a radio frequency (RF) generator or a microwave source. The efficiency of generation of the plasma, or of chemical radicals contained in the plasma, is an important factor in plasma processing. The radicals generated in a plasma are introduced into a reactor (reaction region) for reaction with a material to be worked. Unfortunately, the radicals probably collide with other gas molecules or wall surfaces, to be recombined and lose their chemical activity. It is very important to reduce the recombination of radicals. Bearing in mind these considerations, plasma etching apparatuses of various types have been proposed.

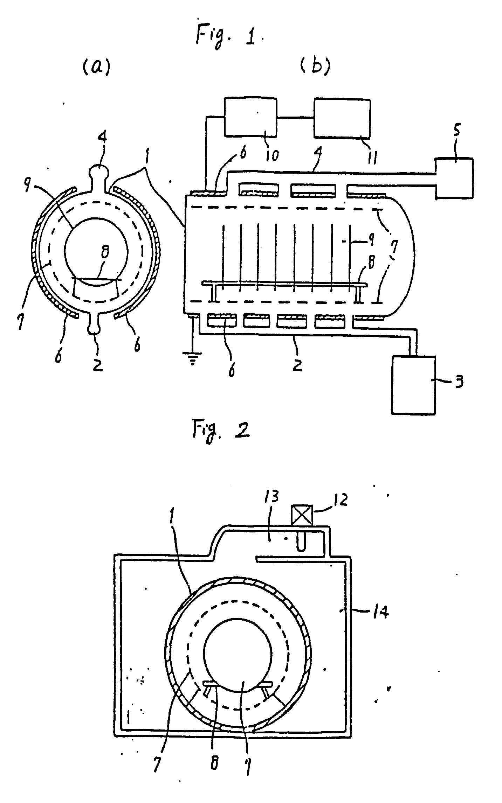

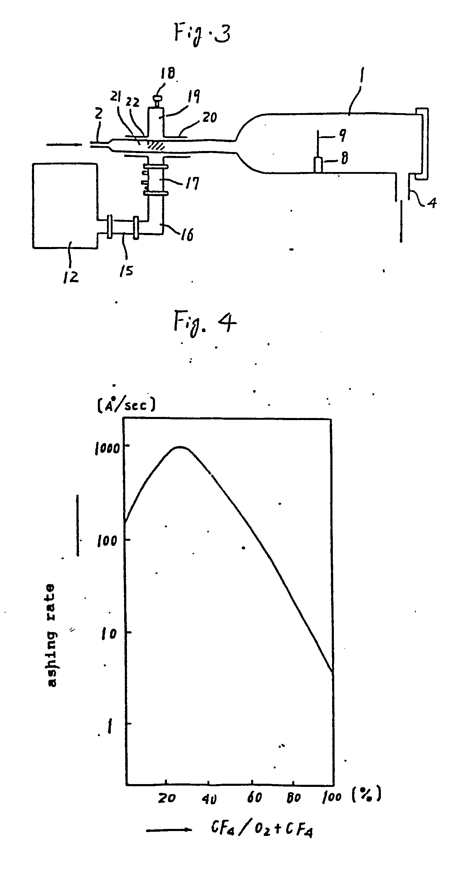

Fig. 1(a) and (b) are, respectively, schematic lateral and longitudinal cross-sectional views of a condenser type plasma etching apparatus having an etch-tunnel.

This apparatus is described in Japanese provisional patent No. 44449/80 and Japanese provisional patent No. 22373/76.

An etching gas is supplied from a source 3 into a reactor 1 through a feeding tube 2. RF energy from an oscillator 11 having a RF (radio frequency) of 13.56 MHz is applied to the gas through electrodes 6 (10 denotes tuning circuitry) and the gas is ionized to generate a plasma in a space between the reactor 1 and a co-cylindrical etching tunnel 7. Chemically active species (hereafter these will be called simply radicals) are generated in the plasma and move through pores provided in the wall of the etching tunnel 7. The radicals reaching the surface of a wafer 9 positioned inside the etching tunnel 7 on a mount 8, react with material on the wafer 9 to form volatile compounds which are removed from the system by a vacuum pumping device 5 through an exhausting tube 4. Thus, the material on the wafer is etched or ashed.

In this apparatus of Fig. 1, a reaction region and a plasma generation region are provided in the same vessel, the reactor 1. The wafer 9 is shielded and protected from the plasma by the etching tunnel 7.

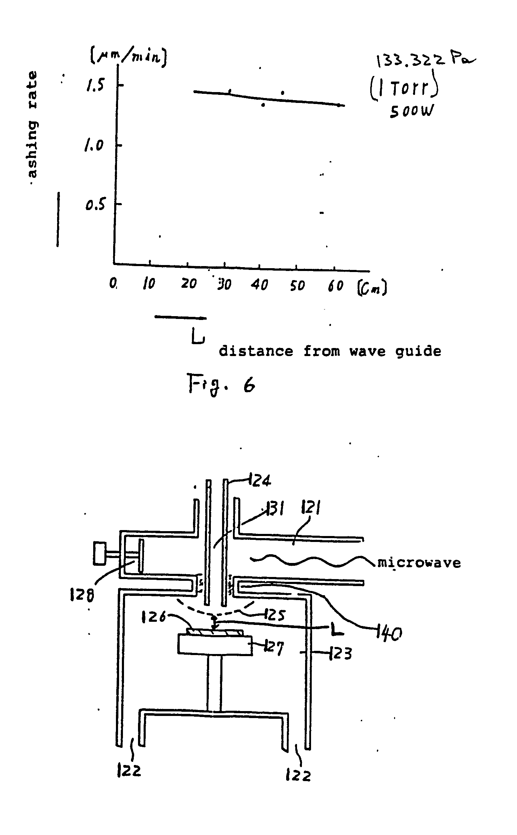

Fig. 2 is a schematic cross-sectional view of a plasma etching apparatus utilizing microwave energy of frequency 2.45 GHz, for generating a plasma.

Microwave energy generated by a magnetron 12 is transmitted into a metallic oven 14 through a waveguide 13. An etching tunnel 7 positioned inside the metallic oven 14 plays the same role as that of the tunnel 7 shown in Fig. 1. However, unlike the case in which radio frequency energy, of frequency 13.56 MHz, is used, a stable plasma is not obtained because of an unstable discharging condition arising due to the shorter wavelength of the microwaves as compared with the dimensions of the reactor (metallic oven 14). In addition, microwave field intensity differs from location to location resulting in the generation of a non-uniformly distributed plasma. As the result, the efficiency of generation of radicals decreases and the rate or efficiency of plasma processing, for example for etching or ashing, decreases significantly.

As a countermeasure against these problems it would be desirable for the metallic oven 14 itself to act as a microwave resonator. However, this is practically speaking impossible to achieve because various metallic devices such as etching tunnel 7 are placed inside the metallic oven 14, and the amount (size and number) of wafers 9 to be processed varies from batch to batch.

In order to overcome the above problems, a chemical dry etching apparatus, having a plasma generating vessel (plasma generation region) and a reactor (reaction region) spaced apart from each other and connected through a tube for guiding radicals from the plasma generating vessel to the reactor has been proposed. In this respect attention is directed to Japanese Patent Toku-Ko-Sho 53-14472 or U.S. patent 4,192,706, 1980 by Horiike. Such apparatus is illustrated in Fig. 3, in a cross-sectional schematic view.

A microwave energy supplying device comprises a magnetron power source 12, an isolator and dummy load 15, a waveguide 16, a tuner 17, a plunger 18, an applicator 19, microwave shield housing 20 and plasma generating vessel 21. Detailed description of these elements is omitted because they will be readily understood by those skilled in the art.

A reactor 1 is positioned remote from the plasma generating vessel 21, spaced from the waveguide (the plasma generation region) by a specified distance L. This spatial separation makes it easy to obtain matching between load impedance (plasma 22) and output impedance of the microwave source 12 (a magnetron) at a frequency of 2.45 MHz, so that microwave energy is absorbed effectively by gas plasma 22, and the efficiency of generation of active species (radicals) is increased significantly. The radicals thus generated are introduced into the reactor 1, where a wafer or other device to be worked (etched) is positioned on a mount 8.

A gas mixture of carbon tetrafluoride ($CF_4$) and oxygen ($O_2$) has been proposed for use as an etching gas and the efficiency of generation of radicals effectively increased by covering the inside wall of the reactor 1 with a ceramic material to prevent or mitigate reduction of the availability of chemically active species.

In an ashing process of photoresist layers or other organic materials, oxygen is an effective reactive gas having a high processing rate, but its radicals generated in a plasma have a short life, which is prolonged by mixing the gas with $CF_4$ gas. As is clearly seen from the curve shown in the graph of Fig. 4, indicating the relationship between ashing rate of a photoresist film and the mixing ratio of $CF_4$ in a $CF_4+O_2$ gas mixture, a mixing ratio, $CF_4/(O_2+CF_4)$, of 30% provides the highest ashing rate. Under this condition, it is reported that almost the same etching rate is obtained for any value of the distance L approximately in the range 30 to 60 cm, as shown in the graph of Fig. 5, which shows the relationship between ashing rate and distance L.

However, another problem arises.

A plasma has a different width of swell (spreads to different extents) during its discharge, depending on the kind of the gas used. A plasma of a gas such as argon (Ar), boron tri-chloride ($BCl_3$), carbon tetra-fluoride ($CF_4$) or the like, having a high flow resistance swells (spreads) widely and a wafer positioned 20 cm away from the waveguide would be immersed in the plasma and damaged. On the contrary, with regard to a reactive gas of oxygen ($O_2$) or chlorine ($Cl_2$), having a low flow resistance, the plasma swells (spreads) little, and radicals generated in the plasma hardly reach the wafer 9 because of their long travelling distance during which the radicals are recombined. Therefore, it is very difficult to determine a suitable distance L.

According to the present invention there is provided plasma processing apparatus, comprising a waveguide for delivering microwaves to a plasma generation region of the apparatus, in which region a reactive gas is subjected to microwaves, to generate a plasma with free radicals, when the apparatus is in use, and a reaction region, in which an object to be processed is placed, to be exposed to the free radicals, when the apparatus is in use, in which apparatus

the plasma generation region is provided within the waveguide and defined by dielectric means through which the microwaves are transmitted to the plasma generation region, and

radical transmission means are provided between the plasma generation region and the reaction region, which means allows the passage of free radicals from the plasma generation region to the reaction region whilst substantially preventing leakage of microwaves and ions contained in the plasma from the plasma generation region to the reaction region.

An embodiment of the present invention can provide microwave plasma processing apparatus for carrying out etching or ashing processes in the fabrication of an IC, having an improved, high processing rate.

An embodiment of the present invention can provide improved microwave plasma processing apparatus for removing photoresist films or for etching off protective layers in the fabrication of integrated circuit semiconductor devices.

An embodiment of the present invention can provide microwave plasma processing apparatus offering a high processing rate, in which reactive gases of various kinds can be used, and in which IC devices being processed are protected from damage due to the plasma.

Briefly, in an embodiment of the present invention a plasma generation region and a reaction region are electrically separated by a shielding means, and electrical design freedom is provided so that the plasma generation region occupies a part of a waveguide of a microwave circuit. As a result, microwave energy is efficiently used for generating a plasma of the reactive gas. A reaction region (reactor) is positioned adjoining the plasma generation region. Namely, the plasma generation region and the reaction region are arranged very close together without any substantial spacing. The reactor and the plasma generation region (a part of the waveguide) are electrically separated by a shielding plate which comprises a part of the wall of the plasma generation region, but adjoined spatially through holes formed in the shielding plate so that the shielding means for the plasma acts as a transmitting means for the radicals. Thus, chemically active species, radicals, generated in the plasma diffuse into the reactor to reach the surface of an object such as a wafer to be etched or ashed. The transporting distance of the radicals is so short that a large number of radicals can reach the surface of the object to the processed before being recombined and losing their chemical activity. As a result, conversion efficiency, namely, number of radicals reacting with the object to be processed per unit microwave energy consumed, will rise significantly, providing the plasma processing apparatus with a high processing rate.

Reference is made, by way of example, to the accompanying drawings, in which:—

Fig. 1(a) is a schematic lateral cross-sectional view of a condenser type plasma etching apparatus having an etch tunnel;

Fig. 1(b) is a schematic longitudinal cross-sectional view of the apparatus of Fig. 1(a);

Fig. 2 is a schematic cross-sectional view of plasma processing apparatus utilizing microwave energy;

Fig. 3 is a schematic cross-sectional view of a microwave plasma etching (chemical dry-etching) apparatus;

Fig. 4 is a graph illustrating the relationship between ashing rate and $CF_4$ concentration of a reactive gas which is a $CF_4$—$O_2$* mixture, for ashing of a photoresist layer;

Fig. 5 is a graph illustrating the relationship between ashing rate and the distance between a reactor and a plasma generating vessel (waveguide) in respect of apparatus as shown in Fig. 3;

Fig. 6 is a schematic cross-sectional view of a plasma processing apparatus used in experiments concerning the present invention and carried out by the inventors;

Fig. 7 is a graph illustrating experimental results, obtained utilizing an embodiment of the present invention, concerning relationships between ashing rate ratio and reactive gas pressure with $CF_4$ concentration in $CF_4$+$O_2$ reactive gas mixtures as a parameter, and

Fig. 8 is a schematic cross-sectional view of plasma etching apparatus embodying the present invention.

Before describing in detail embodiments of the present invention, a detailed explanation concerning reactive gas mixtures will be of assistance.

A report titled "Decapsulation and photoresist stripping in oxygen microwave plasmas' is provided by S. Dzioba and H. M. Naguib in J. Electrochem. Soc.; Vol. 129 No. 11, 1982.

According to this report, oxygen ($O_2$) is found to be a reactive gas with a processing (ashing) rate of 6 μm/min for a photoresist layer, which is significantly faster, by one or two orders, than that of conventional reactive gas. Although the processing is carried out in the afterflow of the discharge, it is found that the concentration of atomic oxygen (radicals) decays rapidly. This is because the survival probability of atomic oxygen is very low. In order to prolong the life of oxygen radicals, $CF_4$ gas is added. Although the ashing rate of the gas mixture is lower than that of pure oxygen gas, the life of radicals generated from the mixed gas is sufficiently longer to allow their employment for a plasma processing apparatus. An object to be processed is positioned apart from a plasma by approximately 30 cm so that the damage of the object due to a plasma can be avoided.

This gas mixture is the reacting gas mixture mentioned above as being proposed for use in plasma processing apparatus.

As mentioned above a 30% mixing ratio of $CF_4$ has been found to provide the highest ashing rate.

However, the inventors have determined that processing rate can be increased by reducing the concentration of $CF_4$ gas in the gas mixture and the shorter life of the mixed gas radicals consequently expected can be prolonged by reducing the distance (L) between the plasma and the object to be processed, and the expected damage for the object by plasma can be avoided by creating a means which prevents the plasma from immersing the object.

The inventors performed experiments using an experimental apparatus embodying the present invention, a schematic cross-sectional view of which is given in Fig. 6.

Microwave energy is transmitted from a microwave power source (not shown) through a waveguide 121. A reactor 123 of silicate glass is connected to the waveguide 121 by a short connecting tube 140. A ceramic tube 124 introduces a reactive gas supplied from a gas source (not shown) into the reactor 123. The system comprising the waveguide 121, the reactor 123 and a ceramic tube 124 is sealed vacuum-tightly (the sealing structure is not shown) and evacuated by a pumping device (not shown) through exhausting tubes 122 attached to the reactor 123.

The ceramic tube 124 passes through the waveguide 121, so reactive gas inside the ceramic tube 124 at the portion in the waveguide is ionized to form a plasma, wherein radicals are generated by the effect of microwave electric field.

The ceramic tube provides dielectric means defining a plasma generation region 131 within the waveguide, through which means microwave power is transmitted to the plasma generation region.

The radicals flow into the reactor 123, where an object 126 such as a semiconductor wafer is mounted on a stage 127. The object 126 is located just nearby the opening of the ceramic tube 124 through which reactive gas is introduced into the reactor, so the distance between the plasma and the object is small, for example several millimetres. This results in a short travelling path for the radicals to reach the surface of the object 126, so the survival probability of the radicals reaching the surface is significantly increased. Thus, a higher processing rate of photoresist, for example, will be obtained. A shield 125 of metallic mesh is positioned around the outside of the ceramic tube 124, for example in the same plane as the bottom plane of the waveguide 121. The shield 125 effectively shields the microwave electric field to prevent plasma from immersing the object 126 to be processed as indicated in Figure 6 with a curved broken line having a reference numeral 125. 128 is a plunger. 140 is a connecting part.

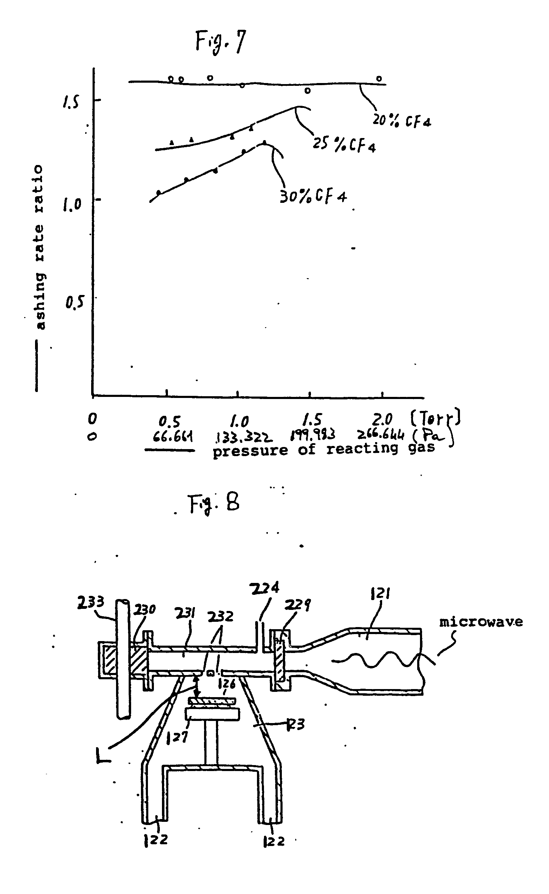

Experiments were performed under various conditions with different $CF_4$ concentrations in a gas mixture of $CF_4+O_2$ as reactive gas and with different gas pressures. Results obtained using the experimental apparatus shown in Fig. 6 are illustrated in the graph of Fig. 7, in which relative ashing rate is plotted on the ordinate and reactive gas pressure is plotted on the abscissa, taking $CF_4$ concentration as a parameter and for a fixed distance L (from the plasma in the plasma generation region—that is, from the shield 125—to the object 126) of 20 mm. The ashing rate with a previously proposed plasma processing apparatus having a reactive gas mixture of $CF_4+O_2$ with a $CF_4$ mixing ratio of 30% is taken as 1. As clearly seen from the curves in Figure 7, an increased ashing rate of approximately 1.5 times the above rate is obtained with a reactive gas of 20% $CF_4$ concentration, and its dependency on the reactive gas pressure is very faint at the gas pressure of 0.5 to 2 Torr. It is found that a reactive gas with lesser concentration of $CF_4$ gas provides a higher ashing rate.

The experiment was repeated for a variety of different distances L from 3 mm to 20 mm. In all these experiments, no change of the characteristics of the object 126, an IC semiconductor, which might be attributed to damage caused by plasma, was observed.

Desirably, the distance between the shield 125 and the object 126 should be no more than 5 cm.

On the basis of the above experimental results, an improved plasma processing apparatus embodying the present invention was developed as illustrated in Fig. 8, which is a schematic cross-sectional view of the apparatus.

Microwave power having a frequency of 2.45 MHz, supplied from a magnetron (not shown) having 400 W output power, is transmitted through a waveguide 121. A plasma generation vessel 231 is substantially a part of the waveguide 121 and partitioned from the other parts of the waveguide 121 vacuum tightly by a ceramic or silica glass window 229. The window 229 provides dielectric means defining a plasma generation region within the waveguide, through which means microwave power is transmitted to the plasma generation region. Wall surfaces (of the waveguide) bounding the plasma generation region may have a ceramic or silica glass coating. A dummy load 230 is attached at the end of the total waveguide, namely, the waveguide 121 including the plasma generation vessel 231, in order to reduce reflection of microwave power. The dummy load is water-cooled by a water-cooling pipe 233. As the result, the microwave power applied to the reactive gas is substantially all travelling wave power and ionizes the gas uniformly. A processing vessel (reactor) 123 is adjoined to the plasma generation vessel 231 through holes 232 formed on a wall of the waveguide 121. The holes 232 act as a shielding means for microwaves to prevent a plasma generated in the vessel 231 from intruding into the processing vessel 123, to protect an object positioned inside the processing vessel 123. At the same time, apparently, the holes 232 act as a transmitting means of the radicals, to allow radicals to pass to the object. The plasma generation vessel 231, the processing vessel 123, and a pumping device (not shown) make up a vacuum system, and the system is evacuated by a vacuum pump through exhausting tubes 122. A reactive gas is introduced into the plasma generation vessel 231 through a gas feeding tube 224, and ionized to form a plasma. Radicals generated in the plasma pass through the holes 232 to reach an object 126 placed in the processing vessel 123 and react with the object 126 forming volatile compounds which are exhausted by the vacuum pump. The distance L between the plasma generation vessel 231 and the object 126 is selected as approximately 0.8 cm. This distance of 0.8 cm is equal to the distance where the plasma may intrude if the shielding means for the plasma, or the transmitting means for the radicals, were taken away. The dimensions of the plasma genertion vessel 231 in the directions of the microwave electric field are reduced as compared with the original waveguide 121, slightly, by 8 mm for example. This reduction of dimensions intensifies the microwave electric field inside the plasma generation vessel 231 increasing the plasma generation efficiency.

Utilizing the apparatus described above, several plasma processing experiments were performed, using a reactive gas mixture of $O_2+CF_4$. The mixing ratio of $CF_4$ was 20% and its pressure inside the plasma generation vessel 231 66.661 Pa (0.5 Torr). The output power of the magnetron was 400 W. A number of silicon wafers of 4 inches diameter having photoresist layers on them were processed, resulting in higher ashing rate 1.5 times that obtained with a previously proposed plasma processing apparatus. In these experimental processings, ashing of the photoresist layers was satisfactory. Photoresist material attached to an undercut portion or a back side portion of a wafer under processing was completely removed. In addition, no damage of the wafer was found and the protection of the wafer was found satisfactory.

Experimental results regarding the ashing of photoresist layers have been described, but the plasma processing apparatus shown in Fig. 8 has also proved to afford similarly high processing rates for etching of protecting layers used in the IC industry, such as layers of silicon, silicon dioxide, silicon nitride (with the employment of suitable reactive gases).

There are several structures for the shielding plate or the transmitting plate for radicals. A large number of holes with small diameters may be formed in the wall of the waveguide 121 to which the processing vessel 123 is adjoined. This wall acts as a shielding plate and also can pass the radicals from the waveguide 121 to the vessel 123. A wire mesh plate can alternatively be used for the shielding plate. For convenience of mounting of the apparatus, a short neck flange having a metallic mesh or mesh-like metallic plate stretched across its opening can alternatively be used. In this case, the neck of the processing vessel should be as short as possible. Desirably, the distance between the shielding means and an object to be processed should be not more than 5 cm.

## Claims

1. Plasma processing apparatus, comprising a waveguide for delivering microwaves to a plasma generation region of the apparatus, in which region a reactive gas is subjected to microwaves, to generate a plasma with free radicals, when the apparatus is in use, and a reaction region, in which an object to be processed is placed, to be exposed to the free radicals, when the apparatus is in use, in which apparatus
the plasma generation region is provided within the waveguide and defined by dielectric means through which the microwaves are transmitted to the plasma generation region, and
radical transmission means are provided between the plasma generation region and the reaction region, which means allows the passage of free radicals from the plasma generation region to the reaction region whilst substantially preventing leakage of microwaves and ions contained in the plasma from the plasma generation region to the reaction region.

2. Apparatus as claimed in claim 1, wherein the dielectric means comprise a dielectric window in the waveguide, which divides one portion of the waveguide, forming the plasma generation region, from other portions of the waveguide.

3. Apparatus as claimed in claim 2, wherein the dielectric window is formed of ceramic material or of silica glass.

4. Apparatus as claimed in claim 2 or 3, wherein the dimensions of the waveguide in the directions of the electric fields of the microwaves are less in the plasma generation region than in the other portions of the waveguide.

5. Apparatus as claimed in claim 1, 2, 3 or 4, wherein the waveguide is terminated by a dummy load, and is such that the microwaves which generate plasma in the plasma generation region substantially consist of travelling waves.

6. Apparatus as claimed in any preceding claim, wherein the reaction region is adjoined to the plasma generation region by way of the radical transmission means, and the distance between the radical transmission means and the location of the object to be processed when the apparatus is in use is no more than 5 cm.

7. Apparatus as claimed in any preceding claim wherein the radical transmission means is a metallic mesh or a metallic grid.

8. Apparatus as claimed in any one of claims 1 to 6, wherein the radical transmission means consist of holes formed in a wall of the waveguide.

9. Apparatus as claimed in any preceding claim, wherein wall surfaces bounding the plasma generation region have a ceramic layer coating or a silica glass coating.

10. Apparatus as claimed in any preceding claim, further comprising
a microwave power source; and
a gas inlet opening through which the reactive gas is fed into the plasma generation region when the apparatus is in use.

11. Apparatus as claimed in any preceding claim, for plasma processing of semiconductor substrates, employing a reactive gas which is a gas mixture of oxygen $O_2$ and carbon tetrafluoride $CF_4$.

## Patentansprüche

1. Plasmabearbeitungsvorrichtung mit einem Wellenleiter zur Lieferung von Mikrowellen zu einem Plasmagenerationsbereich der Vorrichtung, in welchem Bereich ein reaktives Gas den Mikrowellen unterworfen wird, um ein Plasma mit freien Radikalen zu erzeugen, wenn die Vorrichtung in Betrieb ist, und einem Reaktionsbereich, in dem ein zu bearbeitendes Objekt plaziert wird, um den freien Radikalen ausgesetzt zu sein, wenn die Vorrichtung in Betrieb ist, bei welcher Vorrichtung
der Plasmagenerationsbereich innerhalb des Wellenleiters vorgesehen und durch dielektrische Einrichtungen definiert ist, über welche die Mikrowellen zu dem Plasmagenerationsbereich übertragen werden, und
Radikalentransmissionseinrichtungen, die zwischen dem Plasmagenerationsbereich und dem Reaktionsbereich vorgesehen sind, welche Einrichtungen die Passage von freien Radikalen von dem Plasmagenerationsbereich zu dem Reaktionsbereich erlauben, während sie im wesentlichen ein Auslecken von Mikrowellen und Ionen, die in dem Plasma enthalten sind, von dem Plasmagenerationsbereich zu dem Reaktionsbereich verhindern.

2. Vorrichtung nach Anspruch 1, bei der die dielektrische Einrichtung ein dielektrisches Fenster in dem Wellenleiter umfaßt, welches einen Abschnitt des Wellenleiters, der den Plasmagenerationsbereich bildet, von anderen Abschnitten des Wellenleiters teilt.

3. Vorrichtung nach Anspruch 2, bei der das dielektrische Fenster aus keramischem Material oder Kieselglas gebildet ist.

4. Vorrichtung nach Anspruch 2 oder 3, bei der die Dimensionen des Wellenleiters in den Richtungen der elektrischen Felder der Mikrowellen in dem Plasmagenerationsbereich kleiner als in den anderen Abschnitten des Wellenleiters sind.

5. Vorrichtung nach Anspruch 1, 2, 3 oder 4, bei der der Wellenleiter durch eine Blindlast abgeschlossen und derart ist, daß die Mikrowellen, die Plasma in dem Plasmagenerationsbereich erzeugen, im wesentlichen aus Wanderwellen bestehen.

6. Vorrichtung nach einem der vorhergehenden Ansprüche, bei der der Reaktionsbereich dem Plasmagenerationsbereich mittels der Radikalentransmissionseinrichtung angefügt ist, und der Abstand zwischen der Radikalentransmissionseinrichtung und dem Ort eines zu bearbeitenden Objektes dann, wenn die Vorrichtung in Betrieb ist, nicht mehr als 5 cm beträgt.

7. Vorrichtung nach einem der vorhergehenden Ansprüche, bei der die Radiakalentransmissionseinrichtung ein metallisches Sieb oder ein metallisches Gitter ist.

8. Vorrichtung nach einem der Ansprüche 1 bis 6, bei der die Radikalentransmissionseinrichtung aus Löchern besteht, die in der Wand des Wellenleiters gebildet sind.

9. Vorrichtung nach einem der vorhergehenden Ansprüche, bei der die Wandoberflächen, die den Plasmagenerationsbereich begrenzen, einen keramischen Schichtüberzug oder einen Kieselglasüberzug haben.

10. Vorrichtung nach einem der vorhergehenden Ansprüche, ferner mit
einer Mirkowellen-Energiequelle; und
einer Gaseinlaßöffnung, durch welche das reaktive Gas in den Plasmagenerationsbereich eingeführt wird, wenn die Vorrichtung in Betrieb ist.

11. Vorrichtung nach einem der vorhergehenden Ansprüche, zur Plasmabearbeitung von Halbleitersubstraten, unter Verwendung eines reaktiven Gases, welches eines Gasmischung aus Sauerstoff $O_2$ und Kohlentetrafluorid $CF_4$ ist.

**Revendications**

1. Appareil de traitement à plasma qui comprend un guide d'ondes pour fournir des micro-ondes à une région de production de plasma de l'appareil, dans laquelle région un gaz réactif est soumis aux micro-ondes, pour produire un plasma avec des radicaux libres, lorsque l'appareil est en fonctionnement, et une région de réaction, dans laquelle est disposé un objet à traiter, qui doit être exposé aux radicaux libres lorsque l'appareil est en fonctionnement, dans lequel appareil

la région de production de plasma est prévue à l'intérieur du guide d'ondes et est définie par des moyens diélectriques à travers lesquels les micro-ondes sont transmises à la région de production de plasma, et

des moyens de transmission des radicaux sont prévus entre la région de production de plasma et la région de réaction, lesquels moyens permettent le passage des radicaux libres depuis la région de production de plasma jusqu'à la région de réaction tout en empêchant sensiblement les fuites des micro-ondes et des ions contenus dans le plasma depuis la région de production de plasma jusqu'à la région de réaction.

2. Appareil selon la revendication 1, dans lequel les moyens diélectriques comprennent une fenêtre diélectrique dans le guide d'ondes, qui sépare une partie du guide d'ondes, formant la région de production de plasma, des autres parties du guide d'ondes.

3. Appareil selon la revendication 2, dans lequel la fenêtre diélectrique est constituée par un matériau céramique ou un verre de silice.

4. Appareil selon la revendication 2 ou 3, dans lequel les dimensions du guide d'ondes dans les directions des champs électriques des micro-ondes sont plus petites dans la région de production de plasma que dans les autres parties du guide d'ondes.

5. Appareil selon la revendication 1, 2, 3 ou 4, dans lequel le guide d'ondes est terminé par une charge fictive, et est tel que les micro-ondes qui produisent un plasma dans la région de production de plasma consistent sensiblement en ondes progressives.

6. Appareil selon l'une quelconque des revendications précédentes, dans lequel la région de réaction est rendue contiguë à la région de production de plasma par le moyen de transmission des radicaux, et la distance entre le moyen de transmission des radicaux et la position d'un objet à traiter lorsque l'appareil est en fonctionnement n'est pas supérieure à 5 cm.

7. Appareil selon l'une quelconque des revendications précédentes, dans lequel le moyen de transmission des radicaux est une toile métallique ou une grille métallique.

8. Apareil selon l'une quelconque des revendications 1 à 6, dans lequel le moyen de transmission de radicaux consiste en des trous pratiqués dans une paroi du guide d'ondes.

9. Appareil selon l'une quelconque des revendications précédentes, dans lequel les surfaces des parois limitant la région de production de plasma ont un revêtement en une couche céramique ou un revêtement en verre de silice.

10. Appareil selon l'une quelconque des revendications précédentes, comprenant en outre
une source d'énergie hyperfréquence; et
une ouverture d'introduction de gaz par laquelle le gaz réactif est introduit dans la région de production de plasma lorsque l'appareil est en fonctionnement.

11. Appareil selon l'une quelconque des revendications précédentes, pour traiter par un plasma des substrats semi-conducteurs, à l'aide d'un gaz réactif qui est un mélange gazeux d'oxygène $O_2$ et de tétrafluorure de carbone $CF_4$.

Fig. 1

(a)          (b)

Fig. 2

Fig. 3

Fig. 4

Fig. 6

## Fig. 7

ashing rate ratio

1.5

1.0

0.5

20% CF₄

25 % CF₄

30% CF₄

| 0 | 0.5 | 1.0 | 1.5 | 2.0 | [Torr] |
| 0 | 66.661 | 133.322 | 199.993 | 266.644 | (Pa) |

pressure of reacting gas

## Fig. 8

233  230  231  232  224  229  121

microwave

126

127  123

L

122  122